## Europäisches Patentamt

## European Patent Office

## Office européen des brevets

(11) Publication number: **0 055 324**
**B1**

(12) **EUROPEAN PATENT SPECIFICATION**

(45) Date of publication of patent specification: **29.08.90**

(21) Application number: **81106988.9**

(22) Date of filing: **05.09.81**

(60) Divisional application 85114296 filed on 09.11.85.

(51) Int. Cl.⁵: **H 01 Q 1/38,** H 01 Q 3/26,
H 01 P 1/18, H 04 B 1/00

(54) Monolithic microwave integrated circuit with integral array antenna.

(30) Priority: **17.11.80 US 207289**

(43) Date of publication of application:
**07.07.82 Bulletin 82/27**

(45) Publication of the grant of the patent:
**29.08.90 Bulletin 90/35**

(84) Designated Contracting States:
**AT BE CH DE FR GB IT LI LU NL SE**

(56) References cited:
US-A-3 454 906
US-A-3 454 906
US-A-3 778 717
US-A-3 811 128
US-A-3 916 349
US-A-3 921 177
US-A-4 033 788
US-A-4 070 639

IEEE JOURNAL OF SOLID-STATE CIRCUITS, vol.
SC-13, no. 4, August 1978, New York. EDEN,
WELCH, ZUCCA: "Planar GaAs IC Technology:
Applications for Digital LSI", pages 419-425

(73) Proprietor: **BALL CORPORATION**
**345 South High Street**
**Muncie Indiana 47302 (US)**

(72) Inventor: **Stockton, Ronald J.**
**Bonanza Star Route**
**Nederland Colorado 80466 (US)**
Inventor: **Munson, Robert E.**
**7355 Valmont Road**
**BOulder, Colorado 80301 (US)**

(74) Representative: **UEXKÜLL & STOLBERG**
**Patentanwälte**
**Beselerstrasse 4**
**D-2000 Hamburg 52 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 055 324 B1

## Description

The invention relates generally to microwave circuits formed on a gallium arsenide substrate.

US—A—3 454 906 discloses a monolithic integrated circuit microwave element formed on a gallium arsenide substrate. The microwave element comprises a phasing and r.f. feeding network including plural integrated circuit structures electrically connected to control the electric phase shift in r.f. path through the microwave element.

The state of the art in fabrication and construction of millimeter and sub-millimeter wave length microwave systems before the present invention was essentially a "bolt together" waveguide component technology. Individual circuits or discrete components were developed and then interconnected to provide the desired system. In essence, the "blocks" of the overall block diagram of the microwave system were assembled after each "block" was individually developed.

Various problems and shortcomings are inherent in the "bolt-together" approach. One such shortcoming is the high frequency limitation that exists when separate components are bolted together. The size and separation of individual components cannot be scaled proportionally for extremely short wave lengths, resulting in uncontrollable parasitic reactances which limit performance. Other difficulties inherent in the waveguide approach are bulkiness, excessive weight, and high manufacturing costs. In addition, minor design changes can result in costly hardware modifications.

The technology of electronic circuity has evolved from discrete components such as diodes, transistors, capacitors, and resistors on printed circuit boards to the use of monolithic linear and digital integrated circuits. This trend has continued by combining specific integrated circuit functions into larger integrated circuits having versatile and multi-function capability such as in the case of electronic calculators, watches, and micro-computers.

Concurrently with these developments in electronic circuitry, similar techniques have been employed in the technology of microwave circuits. GaAs field effect transistors (FETs) have been developed as well as microwave integrated circuit components such as oscillators, mixers, amplifiers, detectors and filters, using both monolithic and hybrid construction techniques. With the development of the micro-strip radiator, high performance monolithic micro-strip phased arrays have also been developed.

It has been recognized that there are advantages in performance and versatility to be gained by building micro-computer controlled antenna systems. Various multi-mode systems have been developed to demonstrate these advantages. In such systems, the electronics, comprising of integrated circuits mounted on printed boards were packaged separately and interfaced with an antenna by means of a multi-conductor cable.

Such construction represents the present state of the art in microwave system fabrication. To date, complete microwave systems have not been fabricated as a monolithic unit.

## Summary of the Invention

Realizing the inherent disadvantages and shortcomings of the previously utilized "bolt together" technology for the fabrication of millimeter and sub-millimeter wave length microwave systems, it is the primary objective of the present invention to provide a non-optical microwave system incorporating all of the system components including active and/or passive RF components, a microprocessor controller, and digital control circuits into a single monolithic substrate to provide a monolithic phased array antenna system for use at X-band frequencies and above.

In essence, the systems set forth herein represent a unique marriage of the arts of semiconductor and integrated circuit fabrication techniques, used at frequencies lower than microwave, with integrated monolithic electromagnetic system techniques.

The invention recognizes and builds upon the commonality of materials and processes associated with digital and linear integrated circuits, active and passive microwave semiconductor devices, microwave integrated circuits and monolithic antenna systems. The present invention also recognizes that it is both technically advantageous and unique to integrate these devices into a functional monolithic system.

## Brief Description of the Drawings

The invention will now be described in further detail with reference to the accompanying drawings wherein:

Figure 1 is a block diagram of a monolithic microwave integrated circuit receiver according to the present invention;

Figure 2 is a block diagram of a monolithic microwave integrated circuit transmitter according to the present invention;

Figure 3 is a schematic diagram of the equivalent circuit of the single gate FET switch shown in Figure 7;

Figure 4 is a graphical representation of the E-plane half power beamwidth of a sapphire element radiator, plotted from experimental results;

Figure 5 is a cut-away side view of a micro-strip radiator element showing a 90° E-plan half power beamwidth;

Figure 6 is a cut-away side view of a microstrip readiator element showing a 126° E-plane half power bandwith;

Figure 7 illustrates the physical structure of a single gate FET switch used in the phase shifter elements;

Figure 8 is a schematic diagram of the preferred embodiment of one of the 4-bit phase shifters utilizing a hybrid design;

Figure 9 is a physical schematic of a branch line hybrid coupler;

Figure 10 is a backward wave quadrature hybrid coupler; and

Figure 11 is a schematic diagram of a loaded line phase shifter.

## Detailed Description of the Preferred Embodiments

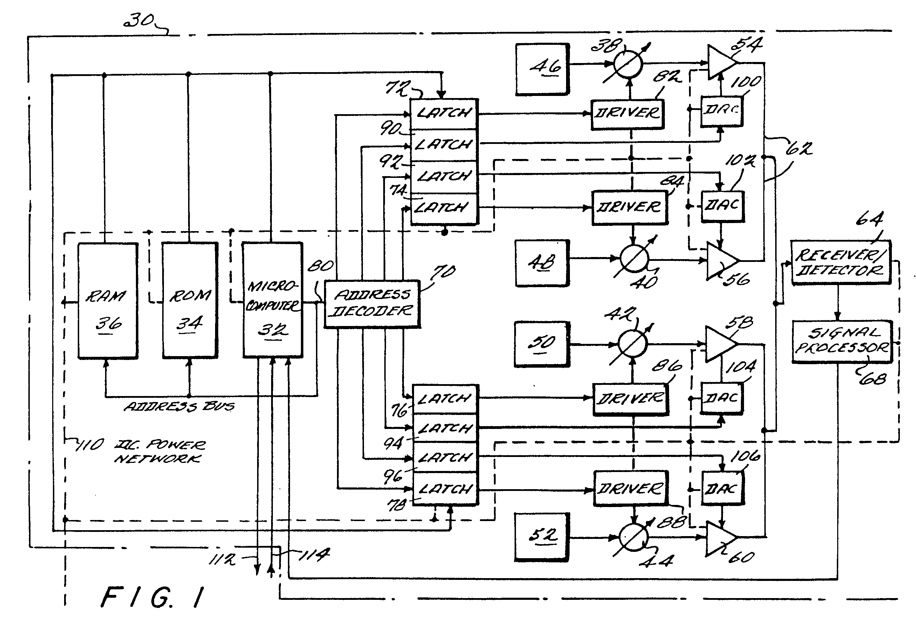

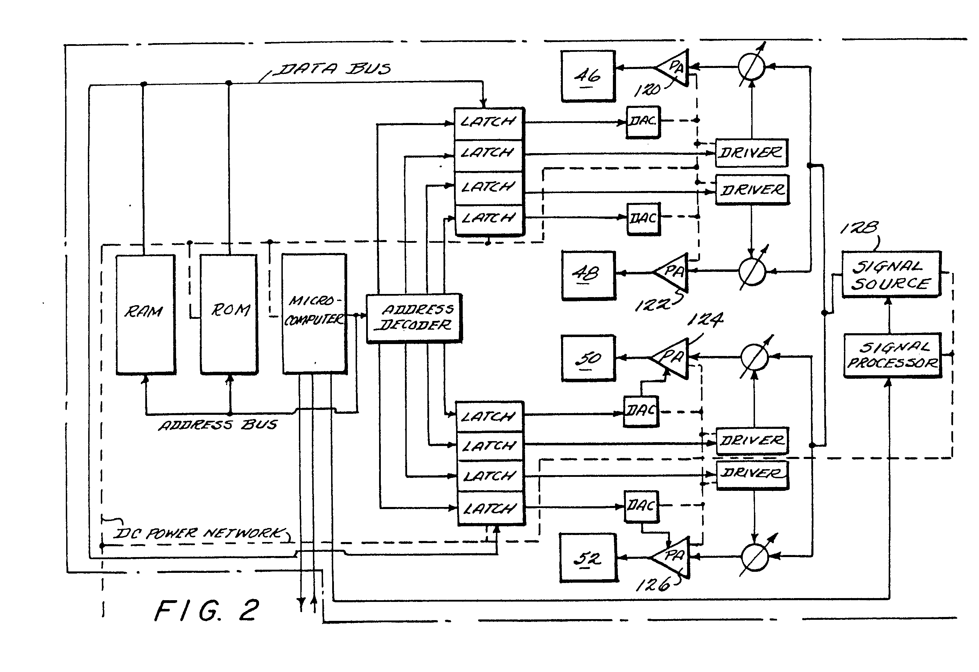

Referring now to Figure 1, there is shown a block diagram of a first embodiment of the monolithic microwave integrated circuit according to the present invention. The embodiment shown in Figure 1 is a four (4)-element microcomputer controlled phased array. The phase array shown in Figure 1 is configured as a receiving array. The corresponding transmitting array is shown in a second embodiment in Figure 2. Continuing to refer to Figure 1, all components are integrated onto a common substrate 30. The phased array is controlled by a microcomputer 32 operating in accordance with a program stored within a read only memory (ROM) 34. The program stored in ROM 34 defines the beam pattern to be followed by the phased array. A random access memory (RAM) 36 provides volatile memory for microcomputer calculations during the execution of its program. For a desired scanning pattern, microcomputer 32, based upon the program of ROM 34 computes the phase setting appropriate for each of four (4) phase shifter elements 38, 40, 42 and 44. The phase shifter elements control the phase shift of the four (4) array elements 46, 48, 50, and 52, respectively.

As previously stated, Figure 1 is a receiver configuration. Signals from array elements 46, 48, 50 and 52, coupled through their respective phase shifters are amplified by low noise amplifiers 54, 56, 58 and 60, associated respectively therewith. The outputs of the amplifiers 54, 56, 58 and 60 are combined by a corporate feed 62 and are coupled to a receiver or detector 64. Output base band signals from receiver or detector 64 are coupled to a signal processor 68 controlled by microcomputer 32.

Microcomputer 32 controls phase shifters 38, 40, 42 and 44 via an address decoder 70 and latches 72, 74, 76 and 78 associated one each with the phase shifters. Data from microcomputer 32 appears in serial fashion on an address bus 80 coupled to address decoder 70. The serial data is latched into latches 72, 74, 76 and 78 and then is transferred to an associated driver 82, 84, 86 and 88 on a single clock pulse. Thus, the phase of each of phase shifters 38, 40, 42 and 44 is shifted simultaneously.

Similarly, the individual gains of low noise amplifiers 54, 56, 58 and 60 are controlled by microcomputer 32 via address decoder 70, latches 90, 92, 94 and 96 and individual digital to analog converters 100, 102, 104 and 106, associated one each with the low noise amplifiers. Serial data from microcomputer 32 is decoded by address decoder 70. Latches 90, 92, 94 and 96 latch the serial information in place and on a single clock pulse the information latched is transferred simultaneously from all latches to the digital to analog converters. Thus, the gains of the low noise amplifiers are changed simultaneously. A DC power network 110 shown in dotted line, distributes power to all active circuit elements. A data output line 112 provides a means for connection to an external sensor or to another microcomputer. A command input line 114 provides an input from an external source such as an operator or another microcomputer. Array elements 46, 48, 50 and 52 are of the general type known in the art, even though not previously fabricated as part of a totally integrated microwave system. Specific examples of array elements 46, 48, 50 and 52 are detailed in U.S. Patent 3,811,128 entitled "Electronically Scanned Microstrip Antenna" and U.S. Patent 3,921,177 entitled, "Microstrip Antenna Structures and Arrays.", commonly owned with the present patent application.

Referring now to Figure 2 there is shown a second embodiment of the monolithic microwave integrated circuit according to the present invention. As previously stated, this figure is a block diagram of a transmitting array corresponding to the receiving array shown in Figure 1. In essence, the transmitting array is configured by exchanging the locations of the phasing networks and amplifiers shown in Figure 1. In addition, the amplifiers 54, 56, 58, 60 of Figure 1 are replaced by voltage controlled power amplifiers 120, 122, 124 and 126; and receiver or detector 64 is replaced by a signal source 128. Otherwise, the remaining elements of Figure 2 are identical to those of Figure 1.

## Semiconductor Medium

The presently preferred embodiments of the monolithic microwave integrated circuit shown in Figures 1 and 2 are fabricated on semi-insulating gallium arsenide (S.I. GaAs). However, other media, such as silicon and/or GaAs on sapphire represent potential alternatives to be considered. At this time, only silicon and gallium arsenide present even possibly practical choices for X-band application because the processing technologies of these media are sufficiently mature so that consistent, repeateable results may be achieved at microwave frequencies. other Groups III—V semiconductor compounds having better theoretical band gap and carrier mobility characteristics may ultimately be well suited for millimeter and sub-millimeter applications, but at the present time neither the material nor processing technology for these compounds has been sufficiently developed to provide the uniformity required for mass production. As a result the presently preferred embodiments, set forth herein, utilizes semi-insulating GaAs, with silicon being the only presently viable alternative, but which has also been ruled out for reasons to be explained in the next paragraph.

In further consideration of the semiconductor medium, PIN diodes fabricated in planar, mesa and beam-lead configurations have been successfully used as switching elements at X-band microwave frequencies and above for over a decade in "bolt together" systems. These devices are made from the highest quality bulk silicon with cutoff frequencies in excess of 2000 GHz. Silicon, however, has a maximum resistivity of only 200—300 ohm-cm undoped. The loss tangent of silicon is therefore many orders of magnitude worse than that of standard microwave substrate materials such as quartz, alumina and sapphire. Typical microstrip transmission lines on silicon have losses of several dB/cm. Thus, the dielectric losses in a microstrip radiator on bulk silicon would reduce aperture efficiency to 20% which is impractical.

The use of a silicon on sapphire (SOS) medium would eliminate this loss problem by allowing the microwave radiator and feedline to be fabricated on the sapphire dielectric leaving silicon only in small areas where PIN diodes need to be fabricated. This would solve one problem but create another. To date the achievable electron mobility, $\mu n$, in SOS epitaxial layers is less than that of bulk silicon. Therefore, PIN diodes suitable for X-band switches are not practical.

Another negative aspect of silicon is that low noise amplifiers are impractical at X-band. This is significant because the ultimate benefits of monolithic microwave integrated circuits and antennas could not be realized in silicon at this frequency.

Microstrip Radiators

Microstrip radiators 46, 48, 50 and 52 are fabricated as a metallization adjacent to the semiconductor material. Layers of Ti-Pt-Au are deposited sequentially on the semiconductor material. The final metalization layer of Au should be at least four (4) skin depths thick at the operating frequency to prevent excessive ohmic losses in the microwave conductors.

In conventional microstrip radiator designs such as illustrated by US—A—3 811 128 and U.S.—A—3 921 177, the choice of a dielectric or substrate material is based on tradeoffs involving phsyical size and efficiency. As an example conventional hybrid microwave integrated circuits are often configured on high dielectric constant substrates with small conductors in order to minmize physical size. Circuit losses in the "bolt together" systems are often not critical since amplification stages can be liberally incorporated. Conversely, microstrip antennas, phasing networks and corporate feed networks are typically restricted to utilizing low dielectric constant materials such as teflon-fiberglass and employ larger conductors to achieve minimum loss, hence maximum gain.

In the presently described monolithic microwave integrated circuit, however, these traditional tradeoffs are overshadowed by totally different requirements imposed by the semiconductor device. Since the performance of a semiconductor component is uniquely related to the physical properties of the material, radiators 46, 48, 50 and 52 are adapted to the semiconductor medium without compromising element performance, i.e., radiation efficiency.

This adaptation is important because high efficiency, typically 90—95%, is an inherent "no-cost" characteristic of microstrip radiators. If this efficiency is inadvertently sacrificed, an amplifying component with its attendant increase in dc power will be required to recover the lost aperture gain. Such a trade-off is not at all attractive and therefore has been avoided.

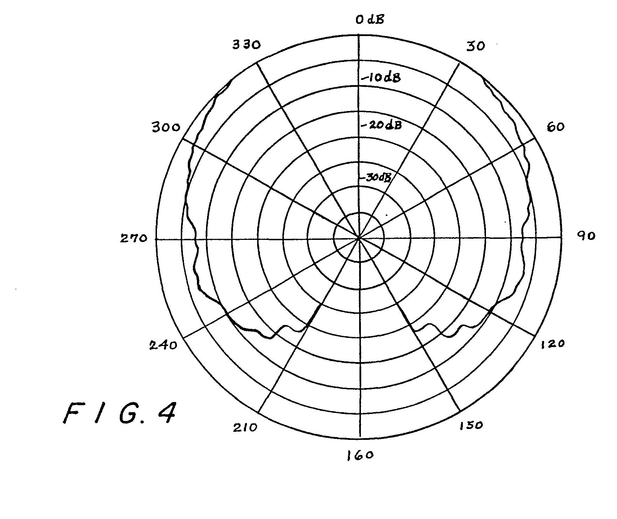

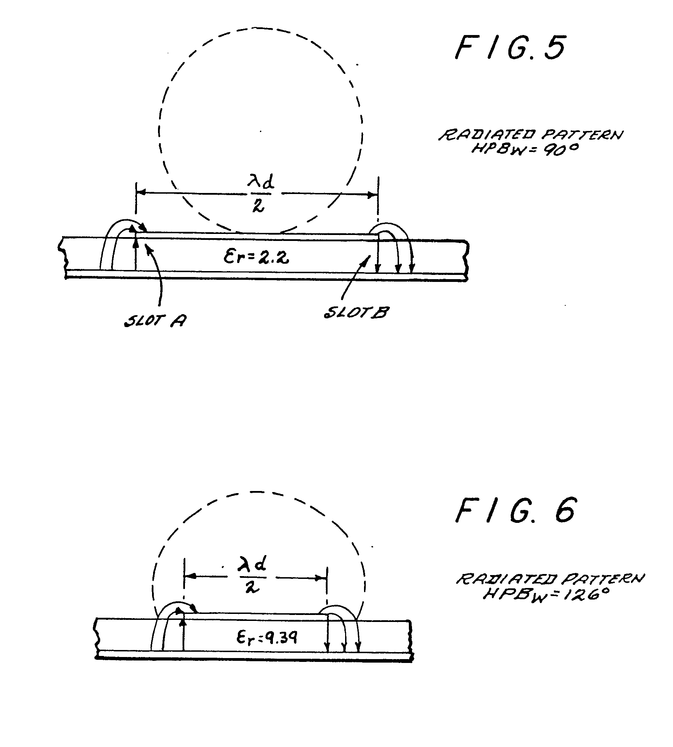

Alternative microstrip radiators using quartz, alumina and sapphire substrates were tested as alternatives for the fabrication of radiators 46, 48, 50 and 52. Optimum performance was obtained for sapphire elements. The E-plane half-power beamwidth of the sapphire radiator was 126 degrees, as shown in Figure 4, which is a computer plot of experimentally measured data. This half power beamwidth is desirable for phased array applications since the element factor does not degrade severely at large scan angles. Such broad beamwidths are characteristic of microstrip elements on high dielectric constant materials, and are explained by the examples shown in Figures 5 and 6.

Referring now to Figures 5 and 6, there are shown cut-away side views of microstrip radiators showing half power beamwidths of 90° and 126°, respectively. In essence the microstrip element is a two slot radiator and the dielectric under the patch can be treated as a low impedance transmission line $\lambda/2$ long connecting slot A and slot B. The half-wavelength property of this transmission line is determined by the dielectric constant of the material, however, the radiated field is a function of the slot separation in terms of free-space wavelength. A typical element on teflon-fiberglass dielectric, $\varepsilon r = 2.2$, is shown in Figure 5 and has a half power beamwidth of 90°. A comparable element of sapphire, $\varepsilon r = 9.39$ is shown in Figure 6. The resonant dimension or slot separation is reduced due to the higher dielectric constant resulting in a smaller aperture, hence broader beamwidth. It is also significant to note that the aperture efficiency of the same sapphire element determined by integration of the far-field readiation patterns is in excess of 93%.

The sapphire element has a 2:1 VSWR bandwidth of 9.5% which is substantially greater than the typical 1—3% bandwidths associated with designs on lower dielectric materials.

Similar performance is obtained on slightly higher dielectric constant materials such as the semi-insulating (S.I.) GaAs with $\varepsilon r = 12.6$ utilized in the preferred embodiment. Efficiency is slightly degraded since the loss tangent of S.I. GaAs having a resistivity of $10^8$ ohm-cm is equivalent to that of 99.6% $AL_2O_3$ or Alumina. The loss tangents for sapphire (mono-crystalline $AL_2O_3$) and S.I. GaAs or Alumina are $2 \times 10^{-5}$ and $1 \times 10^{-4}$ respectively. Although these values are nearly an order of magnitude apart, the additional loss due to increased dielectric dissipatin is negligible since the term is only 1.5% of the conductor loss. The net result, then, is that microstrip radiator aperture efficiencies on GaAs exceed 90%.

## Phase Shifter Switching Elements

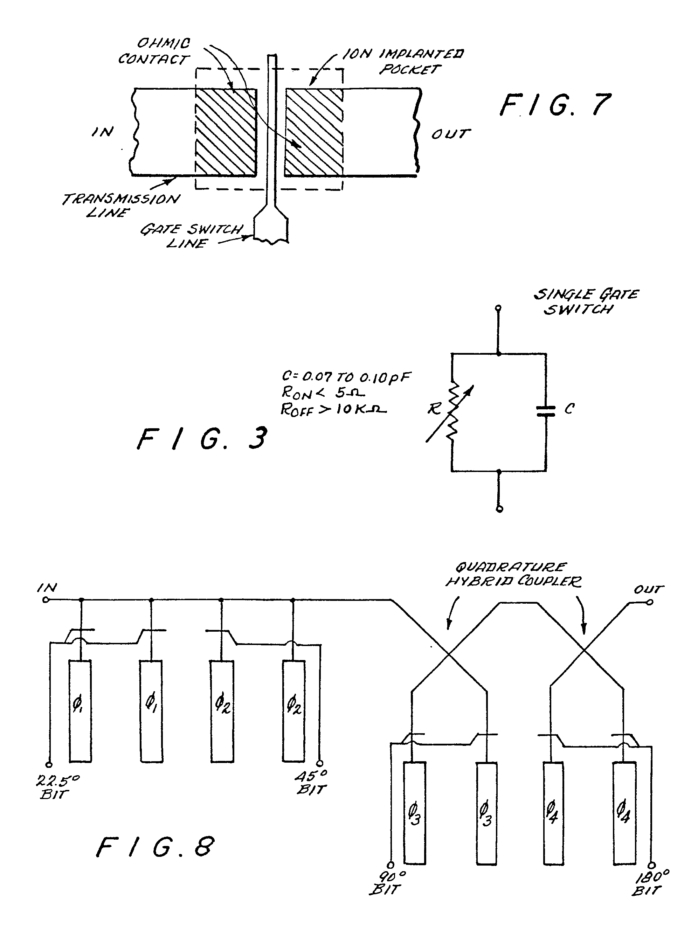

Referring now to Figures 7 and 3, there are shown respectively the physical structure and equivalent circuit of one of the single gate FET switches that are utilized as the switching elements of 4-bit phase shifters 38, 40, 42 and 44. FET switches provide low power consumption and are fabricated using ion implantation planar GaAs technology.

The single gate FET switch, as shown in Figure 7, is turned on and off by application of the appropriate voltage to the gate electrode. The on state is achieved with the gate zero biased or slightly forward biased with respect to the switch terminals. The off state is achieved by biasing the gate beyond the channel pinch-off voltage (negative for the usual n-type depletion-mode GaAs FET). There is no bias applied to the switch terminals for the FET switch.

As a result, there is no distinction between source and drain electrodes in the conventional sense. Also, as in the case of the varactor switch alternative, there is no required sustaining power to hold the FET switch in either the on or the off state. The use of a three terminal (or 4-terminal in the case of the dual gate FET) device for switching greatly simplifies the application of switching bias since the need for dc blocking capacitors is eliminated.

In the on state, the single gate FET switch exhibits a small resistance plus the ohmic contact resistance of the switch terminals. For a 500 µm wide FET with $n^+$ implanted ohmic contacts and a pinch off voltage of about 7 volts, the on resistance can be reduced to about $5\Omega$ or less for a single gate switch and about $7\Omega$ or less for a dual gate switch. Lower on state resistance can be achieved by increasing the width of the switch for a corresponding decrease in resistance but with a resultant increase in shunt capacitance in the off state. The dual gate switch has additional resistance due to the additional channel length required for the second gate. The parasitic series inductance in the on state can be made negligible by integrating the switch into the transmission line. It may be desirable in some applications to intentionally introduce inductance by locating the switch in a section of transmission line away from the ground plane.

The current handling capability of the FET switch in the on state is limited by the drain saturation current which is of the order of 150 mA for the 500 µm wide FET considered earlier assuming zero gate bias. Therefore, if the FET switch is used to effectively short circuit a $50\Omega$ transmission line, the power handling capability in the on mode is about 63 to 100 mW. This power handling capability is more than adequate for switching in a low power phase shifter.

In the off state, the FET switch is essentially non-conductive and the microwave impedance is dominated by the shunt capacitance across the switch terminals which is largely the fringing field capacitance through the semi-insulating GaAs substrate of the gap capacitor formed when the gate is completely pinched off. For a 500 µm wide switching FET, this shunt capacitance is of the order of 0.07 to 0.1pF. At 10 GHz the capacitance of the off switch is about $160\Omega$ to $230\Omega$. Since the off resistance of the FET switch is very high, the dissipation is very small in this state, i.e. reflection coefficients with magnitude near one are obtained. Thus, some form of ballasting or loading may be required to balance the amplitude characteristics between the two switching states. The power handling capability of the switch in the off state is determined by the amplitude of the rf voltage swing which can be sustained across the switch without turning the FET on in one direction or the other. For a single gate switch, the FET will turn on if the bias between the gate and either switch terminal (ohmic contact) becomes less than the pinch off voltage. Thus, the maximum permissible voltage swing across the switch cannot exceed the excess gate bias beyond pinch off. For exsample, if the pinch off voltage is −7V and the gate is biased at −10V, the rf swing at the output of a single gate switch may not exceed 3V peak or 6V peak-to-peak or elase the FET will turn on during negative excursions of the rf voltage. In this example, the power handling capability of the off single gate switch would be about 23 mW into a 50 line which is again entirely adequate for a lowpower phase shifter.

The singel FET switch utilized in the preferred embodiment has the advantages of ease of biasing, power handling capability, and compatibility with existing process technology. There is, in addition, another subtle advantage for the FET switch in terms of control of circuit parameters. The circuit parameters of the FET switch are almost completely defined by the geometry which is established by the photolithography process. For the varactor switch, however, the capacitance in the on and off states is determined by the doping profile, bias voltage, and junction area. Although excellent control is anticipated over doping profiles through the use of ion implantation processes, the FET switch would be expected to hold an advantage in tightness of parameter distributions which would result in superior circuit reproducibility.

## Phase Shifter Circuit

The realization of a 4-bit shifter involves incorporation of the switching elements (FET switches in the preferred embodiment) into circuitry permitting the insertion phase of the phase shifter to be switched in binary increments (22.5°, 45°, 90° and 180°) while maintaining nearly constant input and output VSWR and amplitude uniformity independent of phase.

Referring now to Figure 8, there is shown a schematic diagram of one of the four-bit phase shifters 38—44. The phase shifters utilize FET switching elements, as previously discussed, in a circuit using both switched line and hybrid coupled techniques. The 45° and 22.5° bits use a switched line configuration to reduce area while the 90° and 180° bits utilize a hybrid configuration.

There are alternative phase shifter circuits which may be appropriate to alternative embodiments. The following discussion relates in general to these various alternatives and to the guiding criteria that will aid in the design of other phase shifter circuits.

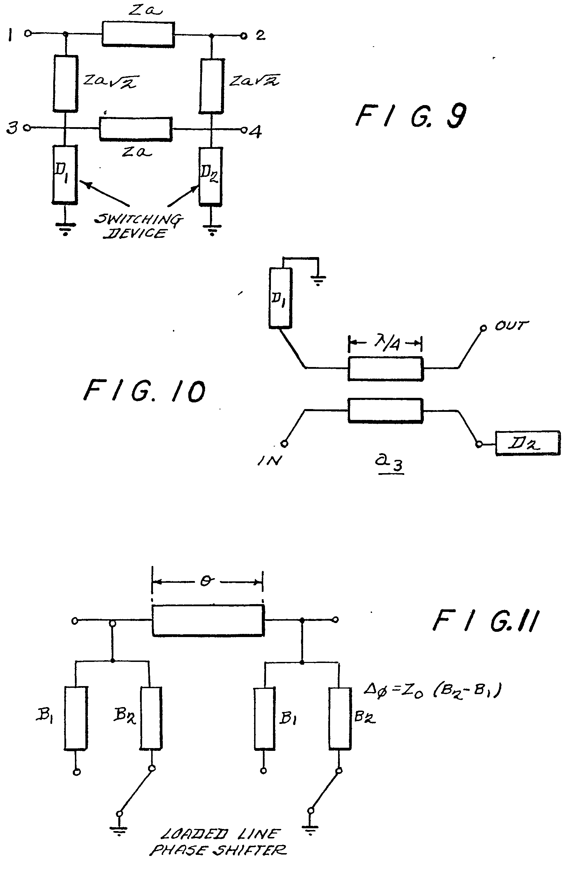

Referring now to Figure 9, there is shown, as another example, a physical schematic of a quadrature hyrid coupler in a branch line configuration. The branch line coupler is limited to bandwith to about 10 to 15 percent since the transmission match, 3 dB power split, and 90° phase shift is only realized for the frequency at which all line lengths are 90°.

The backward wave interdigitated coupler, shown in Figure 10, gives the broadest phase-shifter, bandwidth of all and can be made fairly compact in size. This arises from the fact that although the 3 dB power split is realized only at the center frequency, the 90° phase difference between the coupler output arms, the input match, and the directivity are theoretically frequency independent. Another advantage is that the device is comparatively small and can also be fabricated in a single plane. This coupler typically yields octave bandwidths when designed in stripline, but due to unequal even and odd phase velocities in microstrip line the bandwidth reduces to about 35 to 40 percent. Such bandwidth is more than adequate for element compatibility.

A configuration suitable for the 45° and 22.5° bits is shown in Figure 11. The load-line phase shifter is particularly worth considering with regard to their potential for small size. The loaded line phase shifter offers good VSWR and constant phase shift up to 20 percent bandwidth, but is practically limited to 45° maximum shift for that bandwidth. The design of the load-line phase shifter is based upon two factors. First, a symmetric pair of quarter wavelength spaced shunt susceptances (or series reactances) will have mutually cancelling reflections provided their normalized susceptances are small. Therefore, a good match results regardless of the susceptance sign or value.

**Claims**

1. A monolithic integrated circuit microwave circuit formed on a gallium arsenide substrate including a phasing and r.f. feeding network (38, 40, 42, 44, 62) and plural integrated circuit structures electrically connected to control the electrical phase shift in r.f. paths through the circuit characterized by including a monolithic antenna system comprising:

a plurality of microstrip antenna elements (46, 48, 50, 52) arranged in an array for transmitting/receiving electromagnetic waves;

said phasing and r.f. feeding network (38, 40, 42, 44, 62) being connected to control the electrical phase shift of electrical currents flowing to/from each said element,

said antenna elements and said phasing network being integrated on a single substrate (30) of semi-insulating GaAs semiconductor material having a resistivity of about $10^8$ ohm-cm; and

an integrated ciruit digital microprocessor-based controller means (32, 34, 36) electrically connected to the integrated circuit structures of said phasing network for controlling their operations and said controller means also being monolithically integrated onto said single substrate of semi-insulating GaAs.

2. A monolithic integrated cirucit as in claim 1 wherein:

said antenna elements comprise an array of plural metallized r.f. microstrip antenna radiators (46, 48, 50, 52) formed and disposed on said substrate, each of said radiators having a resonant dimension and at least one edge from/to which r.f. electromagnetic radiation propagates;

said r.f. feeding network comprises an array of metallized r.f. transmission feedlines (62) also integrally formed in said substrate and connected to the edges of said antenna radiators for conducting r.f. electrical signals to/from said radiators;

said phasing network comprises an array of phase-shifting circuits (38, 40, 42, 44) including FET devices also integrally formed on said substrate, individual ones of said phase-shifting circuits being connected to respective ones of said feedlines for controlling the relative r.f. phase shifts encountered by r.f. signals passing to/from said radiators; and

said phasing and r.f. feeding network including an array of controlled-gain amplifier circuits (54, 56, 58, 60) also integrally formed on said substrate, individual ones of said amplifier circuits being connected in circuit with said feedlines for controlling the amplitude of r.f. signals passing from said radiators.

3. A monolithic integrated circuit antenna system as in claim 1 wherein:

said antenna elements comprise at least two receiving array antenna elements (46, 48, 50, 52) each of which includes a metallized resonant radiation element of approximately one-half wavelength dimension at an intended antenna operating frequency;

said phasing and r.f. feeding network (38, 40, 42, 44, 62) is connected to said antenna elements and includes one or more FET devices associated with at least some of said antenna elements for processing r.f. signals received by said antenna elements and for controlling an electrical phase shift associated with the r.f. signals coming from each of said receiving array elements and wherein said integrated circuit microprocessor-based controller means (32, 34, 36) is connected to each of said FET devices for controlling said phasing and r.f. feeding network.

4. A monolithic integrated circuit antenna system according to claim 1, 2 or 3 further including:

a low noise amplifier (54, 56, 58, 60), associated with one or more of the array elements and electrically coupled thereto via a phase shifter of said phasing network, for amplifying r.f. signals from its associated array element, the gain of said amplifiers being controlled by said controller means;

a receiving (64) for detecting signals from said amplifiers; and

said phasing and r.f. feeding network coupling r.f. signals output from said aplifiers to said receiver, said amplifiers and receiver also being integrated onto said single substrate (30) together with said array elements, phasing and r.f. feeding network and controller.

5. A monolithic integrated circuit antenna system according to claim 3 or 4 further including latch means (72, 74, 76, 78) for causing the phase shifts of said phasing network to shift simultaneously, said latch means also being integrated onto said single substrate.

6. An integrated-circuit monolithic antenna system, as in claim 1 wherein:

said antenna elements comprise at least two transmitting array antenna elements (46, 48, 50, 52), each of which includes a metallized resonant radiating element of approximately one-half wavelength dimension at an intended antenna operating frequency; and

said phasing and r.f. feeding network (48, 40, 42, 44, 62) is connected to said antenna elements and includes one or more FET devices associated with at least some of said antenna elements for controlling an electrical phase shift associated with r.f. signals being fed to these transmitting array elements, and said integrated circuit controller means (32, 34, 36) is connected to each of said FET devices for controlling said phasing and r.f. feeding network.

7. A monolithic integrated-circuit antenna system according to claim 6 further including:

a power amplifier (120, 122, 124, 126) associated with one or more of said array elements, and electrically coupled thereto via a phase shifter of said phasing and r.f. feeding network, for providing r.f. signals to its associated array elements, the gain of said amplifiers being controlled by said controller means;

a signal source (128) for providing signals to said amplifiers; and

said phasing and r.f. feeding network coupling r.f. signals input from said signal source to said amplifiers,

said amplifiers and signal source also being integrated onto said single substrate (30) together with said array elements, phasing and r.f. feeding network and controller.

8. A monolithic integrated-circuit antenna system according to claim 6 or 7 further including latch means (72, 74, 76, 78) for causing the phase shifts of said phasing network to shift simultaneously, said latch means also being integrated onto said single substrate.

**Patentansprüche**

1. Monolithische IS-Mikrowellenschaltung auf einem Gallium-arsenidsubstrat mit einem Phasenanpassungs- und HF-Speisungsnetzwerk (38, 40, 42, 44, 62) und einer Vielzahl von IS-Strukturen, die zur Steuerung der elektrischen Phasenverschiebung in HF-Pfaden über die Schaltung angeschlossen sind, gekennzeichnet durch das Vorsehen eines monolithischen Antennensystems mit:

einer Mehrzahl von Mikrostrip-Antennenelementen (46, 48, 50, 52), die als Array für das Senden oder Empfangen von elektromagnetischen Wellen angeordnet sind;

wobei das Phasenanpassungs- und HF-Speisungsnetzwork (38, 40, 42, 44, 62) angeschlossen ist, um die elektrische Phasenverschiebung der elektrischen Ströme zu steuern, die zu oder von den Elementen fließen,

wobei die Antennenelemente und das Phasennetzwerk auf einem einzigen Substrat (30) aus halbisolierendem GaAs-Halbleitermaterial integriert sind, das einen spezifischen Widerstand von etwa $10^8$ $\Omega$-cm hat; und

eine digitale Steuerungseinrichtung (32, 34, 36) auf Mikroprozessorbasis und in Form einer IS, die an die IS-Strukturen des Phasenanpassungsnetzwerks angeschlossen ist, um ihren Betrieb zu steuern, und wobei die Steuereinrichtung ebenfalls auf dem einen Substrat aus halbisolierendem GaAs monolithisch integriert ist.

2. Monolithische IS nach Anspruch 1, wobei:

die Antennenelemente ein Array von mehreren metallisierten HF-Mikrostrip-Antennenstrahlern (46, 48, 50, 52) aufweisen, die auf dem Substrat gebildet und angeordnet sind, wobei jeder der Strahler eine resonante Abmessung und mindestens eine Kante besitzt, von der oder zu der hochfrequente elektromagnetische Strahlung wandert;

wobei das HF-Speisungsnetzwerk ein Array von metallisierten HF-Übertragungsspeiseleitungen (62) aufweist, die ebenfalls integral auf dem Substrat gebildet und an die Kanten der Antennenstrahler angeschlossen sind, um hochfrequente elektrische Signale zu oder von den Strahlern zu leiten;

wobei das Phasennetwerk ein Array von Phasenverschiebungsschaltungen (38, 40, 42, 44) mit FET-Einrichtungen aufweist, die ebenfalls integral auf dem Substrat gebildet sind, wobei einzelne der Phasenverschiebungsschaltungen an jeweilige Speiseleitgungen angeschlossen sind, um die relativen HF-Phasenverschiebungen zu steuern, die von den zu oder von den Strahlern geleiteten HF-Signalen kommen; und

wobei das Phasenanpassungs- und HF-Speisungsnetzwerk ein Array von Verstärkerschlatungen (54, 56, 58, 60) mit gesteuerter Versträkung aufweist, die ebenfalls integral auf dem Substrat gebildet sind, wobei einzelne der Verstärkerschaltungen im Kreis mit den Speiseleitungen liegen, um die Amplitude der HF-Signale zu steuern, die von den Radiatoren kommen.

3. Monolithisches IS-Antennensystem nach Anspruch 1, wobei:

die Antennenelemente zumindest zwei empfangende Array-Antennenelemente (46, 48, 50, 52) aufweisen, von denen jedes ein metallisiertes resonantes Strahlungselement von etwa einer

halben Wellenlängenabmessung bei der beabsichtigten Antennenbetriebsfrequenz aufweist;

wobei das Phasenanpassungs- und HF-Speisungsnetzwerk (38, 40, 42, 44, 62) an die Antennelemente angeschlossen ist und eine oder mehrere FET-Einrichtungen aufweist, die zumindestens einigen der Antennenelemente gehören, um die HF-Signale zu verarbeiten, die von den Antennenelemente aufgenommen werden, und um eine elektrische Phasenverschiebung zu steuern, die zu den HF-Signalen gehört, welche von jedem der empfangenden Array-Elemente kommen, und wobei die integrierte Steuerschaltung (32, 34, 36) auf Mikroprozessorbasis an jede der FET-Einrichtungen angeschlosen ist, um das Phasenverschiebungs- und HF-Speisungsnetzwerk zu steuern.

4. Monolithisches IS-Antennensystem nach Anspruch 1, 2 oder 3, ferner mit:

einem rauscharmen Verstärker (54, 56, 58, 60), der einem oder mehreren der Array-Elemente zugeordnet und an diese über einen Phasenschieber des Phasenanpassungsnetzwerks elektrisch angekoppelt ist, um HF-Signale von seinen zugehörigen Array-Elementen zu verstärken, wobei die Verstärkung der Verstärker von der Steuereinrichtung gesteuert wird;

einem Empfänger (64) zum Erkennen der Signale von den Verstärkern; und

wobei das Phasenverschiebungs- und HF-Speisungsnetzwerk HF-Signalausgaben von den Verstäkern an den Empfänger koppelt, wobei die Verstärker und Empfänger ebenfalls auf dem einen Substrat (30) zusammen mit den Array-Elementen, dem Phasenverschiebungs- und HF-Speisungsnetzwerk und der Steuerungseinrichtung integriert sind.

5. Monolithisches IS-Antennensystem nach Anspruch 3 oder 4, ferner mit Zwischenspeichern (72, 74, 76, 78), die dazu dienen, die Phasenverschiebungen des Phasennetzwerks gleichzeitig zu bewirken, wobei die Zwischenspeicher ebenfalls auf dem einen Substrat integriert sind.

6. IS-monolithsches Antennensystem nach Anspruch 1, wobei

die Antennenelemente mindestens zwei Sende-Array-Antennenelemente (46, 48, 50, 52) aufweisen, von denen jedes ein meallisiertes, resonantes Strahlungselement von etwa einer halben Wellenlängenabmessung bei einer beabsichtigten Antennenbetriebsfrequenz aufweist; und

wobei das Phasenanpassungs- und HF-Speisungsnetzwerk (48, 40, 42, 44, 62) an die Antennelemente angeschlossen ist und ein oder mehrere FET-Einrichtungen aufweist, die zumindestens einigen der Antennenelemente gehören, um eine elektrische Phasenverschiebung zu steuern, die zu den HF-Signalen gehört die diesen Sende-Array-Elementen zugeordnet sind, und wobei die integrierte Steuerungseinrichtung (32, 34, 36) an jede der FET-Einrichtungen angeschlossen ist, um das Phasenverschiebungs- und HF-Speisungsnetzwerk zu steuern.

7. Monolithisches IS-Antennensystem nach Anspruch 6, ferner mit;

einem Leistungsverstärker (120, 122, 124, 126), der zu jedem der einen oder mehreren Array-Elemente gehört und an diese über einen Phasenschieber des Phasenanpassungs und HF-Speisungsnetzwerks elektrisch gekoppelt ist, um HF-Signale an seine zugehörigen Array-Elemente zu legen, wobei die Verstärkung des Verstärkers von der Steuereinrichtung gesteuert wird;

einer Signalquelle (128), um Signale an die Versträker zu legen; und

wobei das Phasenanpassungs- und HF-Speisungsnetzwerk HF-Signaleingaben von der Signalquelle an die Vestärker koppelt,

wobei die Verstärker und die Signalquelle ebenfalls auf dem einen Substrat (30) zusammen mit den Array-Elementen, dem Phasenanpassungs- und HF-Speisungsnetzwerk und der Steuerung gekoppelt sind.

8. Monolithisches IS-Antennensystem nach Anspruch 6 oder 7, ferner mit Zwischenspeichern (72, 74, 76, 78), die es bewirken, daß die Phasenverschiebung des Phasenetzwerks gleichzeitig erfolgt, wobei die Zwischenspeicher ebenfalls auf dem einen Substrat integriert sind.

**Revendications**

1. Circuit en hyperfréquences sous forme d'un circuit intégré monolithique, formé sur un substrat d'arséniure de gallium et comprenant un réseau de déphasage et d'alimentation à haute fréquence (38, 40, 42, 44, 62) et plusieurs structures à circuit intégré connectées électriquement afin qu'elles règlent le déphasage électrique dans des trajets à haute fréquence passant par le circuit, caractérisé en ce qu'il comprend un système à antenne monolithique comprenant:

plusieurs éléments d'antenne (46, 48, 50, 52) à microbandes plates disposés suivant un arrangement d'émission-réception d'ondes électromagnétiques,

le réseau de déphasage et d'alimentation à haute fréquence (38, 40, 42, 44, 62) étant connecté afin qu'il règle le déphasage électrique des courants électriques transmis à chaque élément ou provenant de chaque élément,

les éléments d'antenne et le réseau de déphasage étant intégrés sur un seul substrat (30) d'un matériau semi-conducteur de GaAs semi-isolant, ayant une résistivité d'environ $10^8$ $\Omega$.cm, et

un dispositif (32, 34, 36) à organe de commande à base d'un microprocesseur numérique sous forme d'un circuit intégré connecté électriquement aux structures à circuit intégré du réseau de déphasage et destiné à commander leur fonctionnement, le dispositif à organe des commande étant aussi intégré sous forme monolithique sur le substrat unique de GaAs semi-isolant.

2. Circuit intégré monolithique selon la revendication 1, dans lequel:

les éléments d'antenne sous forme de microbandes plates à haute fréquence (46, 48, 50, 52) formées et disposées sur le substrat, chacun des radiateurs ayant une dimension de résonance et au moins un bord à partir duquel ou vers lequel le rayonnement électromagnétique à haute fréquence se propage,

le réseau d'alimentation à haute fréquence comporte un arrangement de lignes métallisées d'alimentation (62) de transmission à haute fréquence qui sont aussi formées afin qu'elles soient intégrées au substrat et qui sont connectées aux bords des radiateurs d'antenne afin qu'elles conduisent des signaux électriques à haute fréquence vers les radiateurs et à partir de ceux-ci.

le réseau de déphasage comprenant un arrangement de circuits déphaseurs (38, 40, 42, 44) comprenant des dipositifs à transistors à effet de champ qui sont aussi formés de manière intégrée dans le substrat, les circuits déphaseurs individuels étant connectés à des lignes respectives d'alimentation afin que les déphasages relatifs à haute fréquence subis par les signaux à haute fréquence transmis aux radiateurs ou en provenant soient réglés, et

le réseau de déphasage et d'alimentation à haute fréquence comprenant un ensemble de circuits amplificateur (54, 56, 58, 60) dont le gain est réglé et qui sont aussi formés de manière intégrée sur le substrat, les circuits amplificateurs individuels étant connectés aux linges d'alimentation afin que l'amplitude des signaux à haute fréquence provenant des radiatuers soit réglée.

3. Système d'antenne à circuit intégré monolithique selon la revendication 1, dans lequel:

les éléments d'antenne comprennent au moins deux éléments d'antenne d'aérien récepteur (46, 48, 50, 52), chaque élément comprenent un élément métallisé rayonnant à la résonance ayant une dimension approximativement égale à la moitié de la longueur d'onde à une fréquence prévue de fonctionnement de l'antenne,

le réseau de déphasage et d'alimentation à haute fréquence (38, 40, 42, 44, 62) est connecté àux éléments d'antenne et comporte un ou plusieurs dispositifs à transistors à effet de champ associés à certains au moins des éléments d'antenne afin que les signaux à haute fréquence reçus par les éléments d'antenne soient traités et qu'un déphasage électrique associé aux signaux à haute fréquence provenant de chacun des éléments d'aérien de réception soit réglé, et dans lequel le dispositif à organe de commande (32, 34, 36) à microprocesseur sous forme d'un circuit intégré est connecté à chacun des dispositifs à transistor à effet de champ afin qu'il commande le réseau de déphasage et d'alimentation à haute fréquence.

4. Système d'antenne à circuit intégré monolitique selon la revendication 1, 2 ou 3, comprenant en outre:

un amplificateur à faible bruit (54, 56, 58, 60) associé à un ou plusieurs des élémente de l'aérien et couplé électriquement à celui-ci par un déphaseur du réseau de déphasage afin que les signaux à haute fréquence provenant de l'élément associé d'aérien soient amplifiés, le gain des amplificateurs étant réglé par le dispositif à organe de commande,

une récepteur (64) destiné à détecter les signaux des amplifacteurs, et

le réseau de déphasage et d'alimentation à haute fréquence couplant les signaux à haute fréquence provenant des amplificateurs au récepteur, les amplifacteurs et le récepteur étant aussi intégrées sur un substrat unique (30) avec les éléments d'aérien, le réseau de déphasage et d'alimentation à haute fréquence et l'organe de commande.

5. Système d'antenne à circuit intégré monolithique selon la revendication 3 ou 4, comprenant en outre des bascules (72, 74, 76, 78) destinées à provoquer un déclage simultané des déphasages du réseau de déphasage, les bascules étant aussi intégrées sur le substrat unique.

6. Système d'antenne monolitique à circuit intégré selon la revendication 1, dans lequel

les éléments d'antenne comprennent au moins deux éléments d'antenne d'aérien d'émission (46, 48, 50, 52), chacun comprenant un élément métallisé rayonnant à la résonance et ayant une dimension approximativement égale à la moitié de la longeur d'onde à une fréquence prévue de fonctionnement de l'antenne, et

le réseau de déphasage et d'alimentation à haute fréquence (48, 40, 42, 44, 62) est connecté aux éléments d'antenne et comporte un ou plusieurs dispositifs à transistors à effet de champ associés à au moins certains des éléments d'antenne afin que le déphasage électrique associé aux signaux à haute fréquence transmis à ces éléments d'aérien émetteur soit réglé, et le dispositif à organe de commande (32, 34, 36) à circuit intégré est connecté à chacun des dispositifs à transistors à effet de champ afin qu'il commande le réseau de déphasage et d'alimentation à haute fréquence.

7. Système d'antenne à circuit intégré monolithique selon la revendication 6, comprenant en outre:

un amplificateur de puissance (120, 122, 124, 126) associé à un ou plusieurs éléments d'aérien, et couplé électriquement à ceux-ci par l'intermédiaire d'un déphaseur du réseau de déphasage et d'alimentation à haute fréquence afin que les signaux à haute fréquence soient transmis aux éléments associés d'aérien, le gain des amplificateurs étant réglé par le dispositif à organe de commande,

un source de signaux (128) destinée à transmettre les signaux aux amplificateurs, et

le réseau de déphasage et d'alimentation à haute fréquence couplant les signaux à haute fréquence provenant de la source de signaux aux amplificateurs,

les amplificateurs et la source de signaux étant aussi intégrés sur le substrat unique (30) avec les éléments d'aérien, le réseau de déphasage et d'alimentation à haute fréquence et l'organe de commande.

8. Système d'antenne à circuit intégré monolithique selon la revendication 6 ou 7, comprenant en outre des bascules (72, 74, 76, 78) destinées à provoquer un déclage simultané des déphasages du réseau de déphasage, les bascules étant aussi intégrées sur le substrat unique.

FIG. 1

F I G. 2

F I G. 4

FIG. 5

RADIATED PATTERN
HPBW = 90°

$\frac{\lambda_d}{2}$

$\mathcal{E}_r = 2.2$

SLOT A

SLOT B

FIG. 6

RADIATED PATTERN
HPBW = 126°

$\frac{\lambda_d}{2}$

$\mathcal{E}_r = 9.39$

4

FIG. 7

OHMIC CONTACT
ION IMPLANTED POCKET
IN
OUT
TRANSMISSION LINE
GATE SWITCH LINE

SINGLE GATE SWITCH

$C = 0.07$ TO $0.10\,pF$
$R_{ON} < 5\,\Omega$
$R_{OFF} > 10\,K\Omega$

FIG. 3

R    C

QUADRATURE HYBRID COUPLER

IN    OUT

$\phi_1$  $\phi_1$  $\phi_2$  $\phi_2$

$22.5°$ BIT    $45°$ BIT

$\phi_3$  $\phi_3$  $\phi_4$  $\phi_4$

$90°$ BIT    $180°$ BIT

FIG. 8

FIG. 9

$Za$

$Za\sqrt{2}$      $Za\sqrt{2}$

$Za$

$D_1$     $D_2$

SWITCHING DEVICE

FIG. 10

$D_1$

$\lambda/4$    OUT

IN    $a_3$    $D_2$

FIG. 11

$\theta$

$B_1$   $B_2$   $B_1$   $B_2$

$\Delta\phi = Z_0 (B_2 - B_1)$

LOADED LINE PHASE SHIFTER